# EUROPEAN PATENT APPLICATION

(11) **EP 1 727 201 A1**
(43) Date of publication of application: **29.11.2006**
(21) Application number: 05076251.7
(22) Date of filing: 27.05.2005
(51) Int. Cl.: H01L 23/552, H01L 23/29, H05K 9/00

(54) **Shielding material for preventing outleakage and penetration of electromagnetic waves**

(71) Applicant: Hou, PonWei, Hsin-Chu City (TW)
(72) Inventor: Hou, PonWei, Hsin-Chu City (TW)
(74) Representative: Gillam, Francis Cyril

(57) **Abstract**

An EM (electromagnetic wave) shielding material and an EM shield contains a material composition comprising a magnetic powder made of at least one EM absorbing element or compound in a discrete particle form and a binding compound to bind the discrete particles in a layer or paste. The discrete particles are made of one or more metals such as Fe, Ni, Cr and Mn or dielectric compounds having magnetic properties. The binding compounds can be selected from silicone, rubber, acrylonitrile butadiene styreneresin (ABS), polycarbonate (PC), epoxy, silica and polyurethane. The shielding material may further comprise associated components which can be selected from zinc oxide, magnesium oxide, ethylene thiourea, carbon black, and stearic acid. The material can also be used as a packaging material for electronic components in an electronic product.

## Description

### FIELD OF THE INVENTION

The present invention relates generally to electromagnetic shielding and, more particularly, to a shielding package made of a shielding material for reducing the penetration of electromagnetic waves through the shielding package.

### BACKGROUND OF THE INVENTION

Electrical parts in the electrical products, such as a clock generator, integrated circuit (IC) and central processing unit (CPU) etc, often form electric loops when they are in operation. As such, they are apt to produce electromagnetic waves. Moreover, conducting wires of the electrical products may also produce electromagnetic waves. The antenna effect, namely the radiation effect of electromagnetic waves produced by electrically conductors, is dependent upon to length of the conductors and the surrounding area of the conductors. The antenna effect may enhance the radiation of electromagnetic waves. These unwanted electromagnetic waves may interfere with the normal operations of other electrical products, and may also be harmful to human beings and other living creatures. Moreover, electrical products in pursuit of miniaturization and high-speed transmission render the radiation effect of electromagnetic waves on these electrical products more serious.

It is known in the art that materials such as wood and plastic cannot prevent electromagnetic waves from penetration therethrough. Even a shield made of a metal does not effectively reduce the harmful effect of electromagnetic pulses (EMP) and electromagnetic interference (EMI). Certain metals can change the direction of an imposing electric field, but they do not effectively absorb electromagnetic waves. Thus, electromagnetic energy still exists in and around a metal shield.

Capacitance has been used to reduce the radiation of electromagnetic waves produced by an antenna. The inductance effect associated with a ferrite core has also been employed to reduce electromagnetic radiation. However, these methods cannot be used to protect an electrical component in a package, for example.

It is thus desirable and advantageous to provide a material and product for reducing the effect of electromagnetic waves produced by electrical products on the surrounding environment. It is also desirable to protect electrical products from being damaged by external EMP or subject to EMI.

### SUMMARY OF THE INVENTION

It is a primary object of the present invention to provide a material that effectively absorbs energy associated with electromagnetic waves. With energy absorption, at least some of the electromagnetic waves that encounter the material are transformed into to heat energy, thereby reducing the radiation of electromagnetic waves through the material.

It is another object of the present invention to provide a shielding layer made of the EM absorbing material. With such a shielding layer, the electromagnetic waves produced by electrical components within the layer can be effectively prevented from causing harmful or undesirable effects in the surrounding. Furthermore, the shielding layer can also protect electrical components within the package from being damaged or interfered by external electromagnetic waves.

The shielding layer of the present invention contains a material composition comprising:
at least one EM absorbing element or compound in a discrete particle form; and
at least one binding compound to bind the discrete particles in a layer and, at the same time, to provide electrical insulation between adjacent particles.

Furthermore, the composition may comprise some associated components as an agent to harden the shielding layer or to add firmness to the shielding layer.

The EM absorbing element or compound in the discrete particle form is herein referred to as a magnetic powder. The powder can be made of one or more metals such as Fe, Ni, Cr and Mn, but it can also be made of dielectric compound having magnetic properties.

The binding compounds can be selected from silicone, rubber, acrylonitrile butadiene styreneresin (ABS), polycarbonate (PC), epoxy, silica and polyurethane;

The associated components can be selected from zinc oxide, magnesium oxide, ethylene thiourea, carbon black, and stearic acid.

The material composition is produced in a mixture of the selected components with proportional weights in order to maximize energy transference for a given range of frequencies.

The material can be integrated in a packaging material for one or more electronic components in an electronic product.

The present invention will become apparent upon reading the description taken in conjunction with Figures 1 to 8.

### BRIEF DESCRIPTION OF THE DRAWINGS

By way of example only, the present invention will now be described in greater detail, with reference to the drawings.

Figure 1 is a schematic representation showing a cross sectional view of a shielding housing, according to one embodiment of the present invention.

Figure 2 is a schematic representation showing a cross section of a shielding housing with multiple compartments, according to another embodiment of the present invention.

Figure 3 is a schematic representation showing a flexible shielding layer for use in wrapping around one or more electronic components.

Figure 4 is a schematic representation showing the shielding material being used as a paste to be applied around one or more electronic components.

Figure 5a is a schematic representation showing the shielding material being used as the packaging material for an electronic component in an electronic product.

Figure 5b is a schematic representation showing the shielding material being used as part of the packaging material for an electronic component in an electronic product.

Figure 5c is a schematic representation showing the shielding material being used as an interior part of the packaging material for an electronic component in an electronic product.

Figure 6 is a schematic representation showing the binding of magnetic particles in a shielding layer.

Figure 7 shows a microwave characteristic of the shielding package, according to the present invention, wherein the electromagnetic waves used in the absorption measurement are in the Bluetooth frequency band (S frequency band of 2-4 GHz).

Figure 8 shows a microwave characteristic of the shielding package of the present invention, wherein the electromagnetic waves used in the absorption measurement are in the satellite communication band (Ku frequency band of 12-18 GHz).

### DETAILED DESCRIPTION OF THE INVENTION

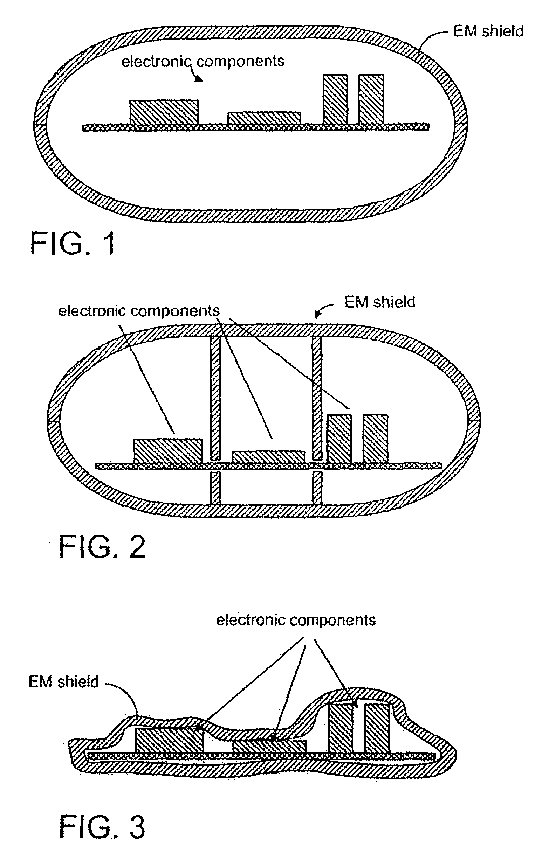

Figures 1 to 4 show a shielding layer made of the EM absorbing composition, according to the present invention. The composition comprises:
at least one magnetic powder, and
at least one binding compound for binding the magnetic powder in a layer.

Additionally, the composition may comprise one or more associated compounds to change the firmness of the layer.

The magnetic powder is made of one or more elements or compounds that have magnetic properties. The elements or compounds can be electrically conductive or a dielectric. For example, the powder can be made of Fe, Ni, Cr or Mn or the combination thereof.

The binding compounds can be selected from silicone, rubber, acrylonitrile butadiene styreneresin (ABS), polycarbonate (PC), epoxy, silica and polyurethane;

The associated components can be selected from zinc oxide, magnesium oxide, ethylene thiourea, carbon black, and stearic acid.

Due to the electromagnetic wave absorption of the composition, electrical components placed inside the shielding package can be effectively protected from external electromagnetic pulses (EMP) and electromagnetic interference (EMI). Furthermore, the shielding package also substantially prevents electromagnetic waves produced by the electrical components placed inside the shielding package from penetrating through the package.

Figure 1 shows a shielding housing made of a hardened shielding material, according to the present invention. When electronic components are placed inside the housing, the electronic components are protected from being damaged or interfered by external electromagnetic waves. Such a housing can also prevents the electromagnetic waves produced by the electronic components within the housing from causing harmful or undesirable effects in the surrounding.

Figure 2 shows a shielding housing having two or more chambers for housing a plurality of electrical components. The chambers are separated by partitioning walls also made of the shielding material, according to the present invention. As such, the electrical components placed inside the shielding package can also be protected from electromagnetic waves produced by the electrical components in neighboring compartments.

In general, the magnetic powder and one or more of binding compounds made up 60% to 95% by weight of the composition. The magnetic powder (available from Fluka Inc., Switzerland, for example) has a particle diameter of 1-200µ, density of 1-20 g/ml, and is present in the range of 30 - 90 % by weight. The powder can be coarser containing larger particles if the shielding layer is reasonably thick. Thus, the magnetic powder, in general, contains discrete particles of certain sizes depending on the applications.

The binding material can be composed of one or more of the following compounds: silicone, rubber, ABS, PC, epoxy, silica and polyurethane. The binding material is present in the composition in the range of 5% to 65% by weight.

The associated components selected from zinc oxide, magnesium oxide, ethylene thiourea, stearic acid and carbon black etc. are present in the range of 5% - 40% by weight, total.

One of the ways to prepare the shielding layer is as follows: The blend of the mixed composition is heated in a mold for about 3 - 30 minutes at temperature of about 130°~190° centigrade to become a hard shell with a thickness of 0.1 to 20 mm of a desirable size and shape. The shell can be flat, curved, round or another shape, depending on the shape of the mold. With a shielding housing having two or more compartments, as shown in Figure 2, it is possible that the partitioning walls are formed together with the shell, or one or more separate sheets of the shielding material are added the shell to make electromagnetic wave barriers between compartments.

Depending on the type and the amount of associated components in the composition, the shielding layer can be also made into a flexible sheet so that the sheet can be into a bag so that electronic components or circuits can be shielded from external EMP or EMI. The flexible sheet can also be used to wrap around a circuit board as shown in Figure 3, for example.

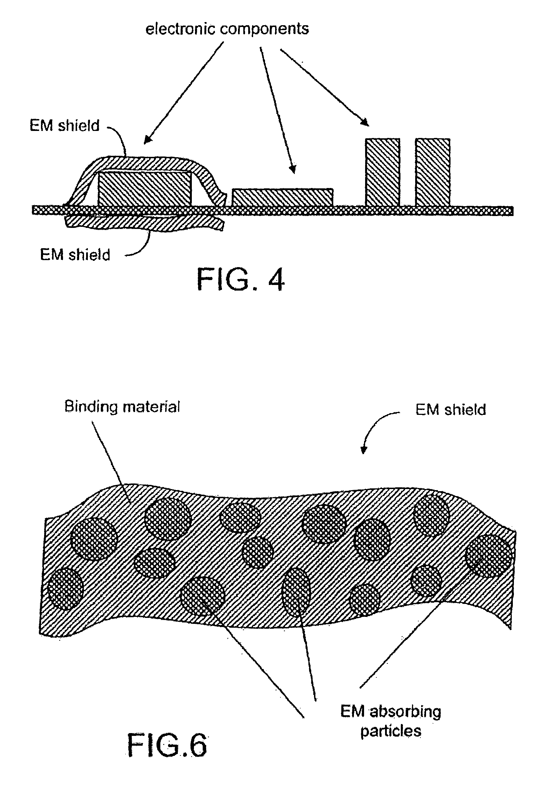

The shielding material can also be made into a paste-like substance so that it can be selectively applied on small sections of a circuit board as shown in Figure 4, for example.

Depending on the mixtures, the electromagnet wave material, according to the present, may be made as a sponge-like material by a different process.

The electromagnetic waves from the electrical components or from outside of the shielding layer, are prevented from penetrating through the shielding layer by absorption. However, the heat produced by the absorption is generally low as compared to the heat produced by the current consumption in the electrical components.

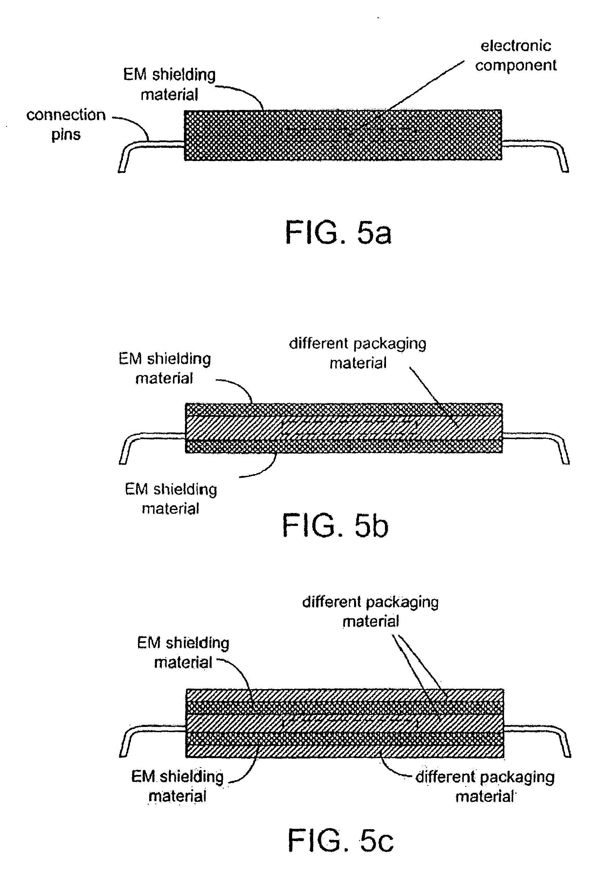

The EM shielding material of the present invention can be as a packaging material for electronic component in an electronic product. For example, the EM shielding material can be used as the packaging material for a regular integrated circuit (IC) or that for an application specific integrated circuit (ASIC). The shielding material can be used to form a packaging shell for an RF transceiver. As shown in Figure 5a, the EM shielding material of the present invention is used as the entire packaging material for an IC. However, the shielding material can also be used as part of the packaging, as shown in Figures 5b and 5c.

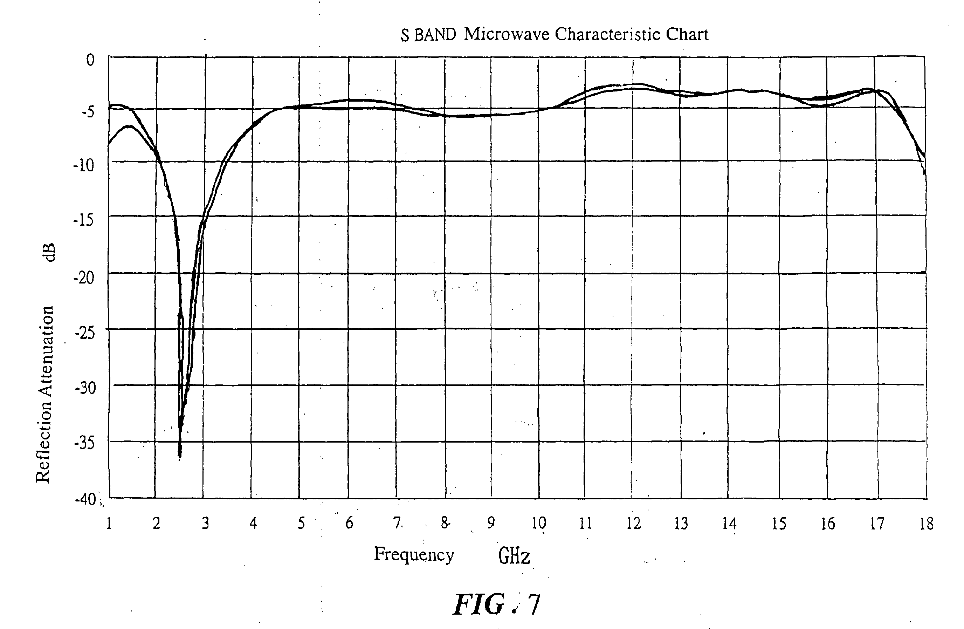

Figure 6 is a schematic representation showing how the magnetic powder is distributed in a shielding layer. As shown in Figure 6, the discrete particles in the magnetic powder are separated by the binding material so that electromagnetic waves absorbed in the particles are prevented from being transferred to neighboring particles by electrical conduction. As such, the electromagnetic waves absorbed in the particles are locally trapped so that the energy associated with the electromagnetic waves is transferred to the surrounding area as heat.

A few examples of the composition for making a shielding layer are shown below:

### Example 1

(1) Preparing and mixing a material composition - total 100 grams, including:
   magnetic powder - 70 grams, size 15µ, density 4 grams/ml;
   rubber - 15 grams
   zinc oxide - 3 grams
   magnesium oxide - 4 grams
   ethylene thiourea - 2 grams
   carbon black - 4 grams
   stearic acid - 2 grams
(2) Put the mixed material in a mold or container, heat to 180°C for 15 minutes;
(3) Subject the mixed material to a pressure by 150 kg/cm²;
(4) Cool the mixed material;
(5) Take the hardened material off the mold.

With a thickness of about 3mm, a shielding package made from this mixture is effective against the electromagnetic waves in the Bluetooth frequency band (S frequency band of 2-4 GHz).

### Example 2

(1) Prepare and mixing a material composition - total 100 grams, including:
   magnetic powder - 55 grams, size 20 µ,density 3 grams/ml
   silicone - 30 grams
   zinc oxide - 3 grams
   magnesium oxide - 4 grams
   ethylene thiourea - 2 grams
   carbon black - 4 grams
   stearic acid - 2 grams
(2) Put the mixed material in a mold or container, heat to 130°C for 10 minutes;
(3) Subject the mixed material to a pressure by 130 kg/cm²;
(4) Cool the mixed material;
(5) Take the hardened material off the mold.
With a thickness of 1.6mm, a shielding package made from this mixture is effective against the electromagnetic waves in the satellite communication frequency band (Ku frequency band of 12-18 GHz).

### Absorption Measurement 1

A shielding package made from the mixed material of Example 1 is used to measure the electromagnetic wave absorption in the Bluetooth frequency band (S frequency band of 2-4GHz). The data of electromagnetic wave absorbing effect is shown in Figure 7. In the chart as shown in Figure 7, coordinate X represents the electromagnetic wave frequency (GHz), and coordinate Y represents reflection attenuation (db). The experiment proves that the electromagnetic wave energy can be transferred to heat energy, giving rise to a negligible temperature increase.

### Absorption Measurement 2

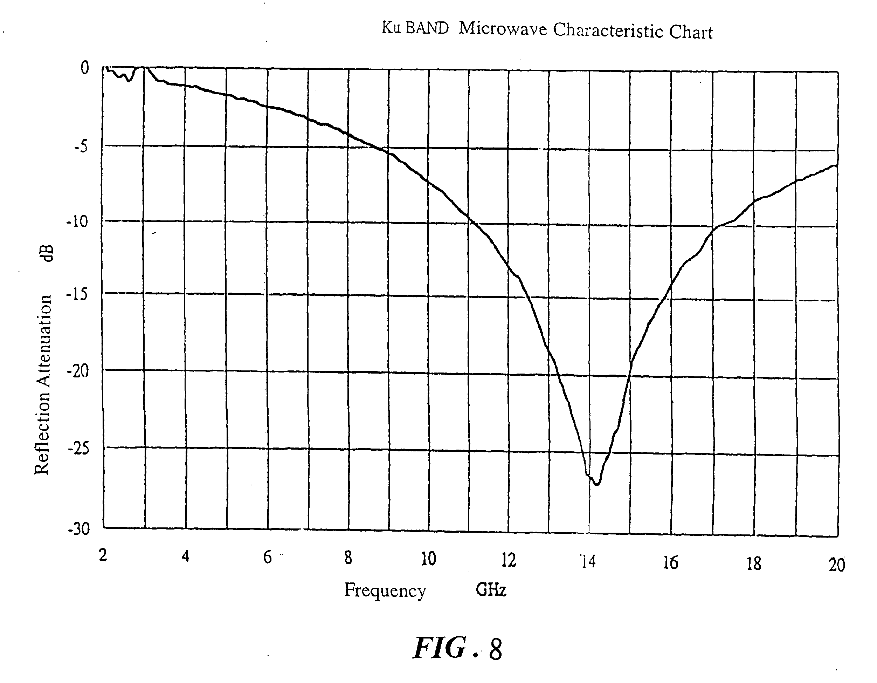

A shielding package made from the mixed material of Example 2 is used to measure the electromagnetic wave absorption in the satellite communication frequency band (Ku frequency band of 12 - 18 GHz). The data of electromagnetic wave absorbing effect is shown in Figure 8. In the chart as shown in Figure 8, coordinate X represents the electromagnetic wave frequency (GHz), and coordinate Y represents reflection attenuation (db).

In addition to the shielding layer, according to the prevention, a second shielding unit may be added onto the shielding layer in order to enhance the transference capability of the energy transference unit. The second shielding layer may be made of a metal sheet, such as gold, silver, copper, iron, aluminum, platinum, stainless steel, ITO, an alloy, or an electromagnetic wave shielding film that is not grounded.

Furthermore, the shielding layer, according to the present invention, can be made thicker or thinner depending on the protection desired. The shielding layer can also be made of a number of sub-layers of the mixed material.

The shielding product made of the EM absorbing material, according to the present invention, can be made into a hard shell, a flexible sheet or layer, or a paste as shown in Figures 1 to 4. However, it may be possible to make the product more liquid-like so that the product can be sprayed or brushed on one or more electronic components.

It is possible to add a secondary shielding layer adjacent to an EM shielding layer in order to enhance the energy transference capability of the EM shielding layer. The secondary shielding layer can be made of metal or metal compound such as gold, silver, copper, iron, aluminum, platinum and stainless steel. The secondary shielding layer need not be grounded.

Thus, although the invention has been described with respect to one or more embodiments thereof, it will be understood by those skilled in the art that the foregoing and various other changes, omissions and deviations in the form and detail thereof may be made without departing from the scope of this invention.

## Claims

1. A shielding material for use in reducing the effect of electromagnetic waves on electronic components or the surroundings, comprising:
a magnetic powder made of one or more electromagnetic wave absorbing materials in a discrete particle form; and
a binding component for binding the magnetic powder.

2. The shielding material of claim 1, wherein one or more of the electronic components have a packaging material surrounding said one or more electronic components, and wherein said shielding material is integrated in the packaging material.

3. The shielding material of claim 1 or claim 2, wherein the magnetic powder is made of one or more metallic elements or compounds.

4. The shielding material of claim 3, wherein the magnetic powder is made of one or more elements selected from the group consisting of Fe, Ni, Cr and Mn.

5. The shielding material of claim 1 or claim 2, wherein the magnetic powder comprises one or more dielectric materials having magnetic properties.

6. The shielding material of any of the preceding claims, wherein the binding material is made of one or more elements selected from the group consisting of silicone, rubber, acrylonitrile butadiene styreneresin, polycarbonate, epoxy, silica and polyurethane.

7. The shielding material of any of the preceding claims, further comprising an associate component for defining the physical properties of the shield material in a processed product.

8. The shielding material of claim 7, wherein the associated component is selected from zinc oxide, magnesium oxide, ethylene thiourea, carbon black, and stearic acid.

9. The shielding material as claimed in any of the preceding claims and formed into a shielding product for use with electronic components, the product comprising a layer adapted for disposing adjacent to one or more electronic components so as to allow the layer to absorb electromagnetic waves in the proximity of said one or more electronic components.

10. The shielding material of claim 9, wherein the shielding product is formed as a layer of packaging material used to encase or surround one or more electronic components.

11. The shielding material as claimed in any of claims 1 to 8 and formed into a paste for application on or adjacent to one or more electronic components so as to allow the paste to absorb electromagnetic waves in the proximity of said one or more electronic components.
